Europäisches Patentamt

European Patent Office

Office européen des brevets

(11) Veröffentlichungsnummer: **0 358 099**

**A2**

(12) **EUROPÄISCHE PATENTANMELDUNG**

(21) Anmeldenummer: 89115972.5

(22) Anmeldetag: 30.08.89

(51) Int. Cl.5: **G01V 9/04**

(30) Priorität: 09.09.88 DE 3830658

(43) Veröffentlichungstag der Anmeldung:
14.03.90 Patentblatt 90/11

(84) Benannte Vertragsstaaten:
**AT BE CH DE ES FR GB IT LI NL**

(71) Anmelder: **DI-SORIC INDUSTRIE-ELECTRONIC GMBH & CO**
**Steinbeisstrasse 6**
**D-7068 Urbach(DE)**

(72) Erfinder: **Schellong, Hellmut**
**Hauptstrasse 25**
**D-4952 Porta Westfalica(DE)**

(74) Vertreter: **Ninnemann, Detlef, Dipl.-Ing.**
**Patentanwalt**
**Delbrückstrasse 8**
**D-2800 Bremen 1(DE)**

(54) Vorrichtung zur Erfassung einzelner Gegenstände.

(57) Vorrichtung zur Erfassung einzelner Gegenstände mit einer Sensoreinrichtung, die mehrere beabstandet zueinander angeordnete Sender- und Empfängerelemente aufweist, zwischen denen die einzelnen Gegenstände hindurchtreten und einer Auswerteinrichtung. Die Empfängerelemente (3) sind in mindestens drei gleichgroße Gruppen (11, 12, 13, 14) mit benachbart zueinander angeordneten Empfängerelementen (3) aufgeteilt. Die Auswerteinrichtung enthält mindestens zwei Differenzbildner (31, 32, 33, 34) und die Ausgänge von jeweils zwei Empfängerelementegruppen (11, 12, 13, 14) sind mit den Eingängen jeweils eines Differenzbildners (31, 32, 33, 34) verbunden, deren Ausgänge ein die Erfassung eines Gegenstandes anzeigendes Signal abgeben.

## Vorrichtung zur Erfassung einzelner Gegenstände

Die Erfindung betrifft eine Vorrichtung zur Erfassung einzelner Gegenstände gemäß dem Oberbegriff des Anspruchs 1.

Es sind Gabel- oder Rahmenlichtschranken zur Erkennung metallischer und nichtmetallischer Gegenstände bekannt, die als Impulsgeber vorzugsweise dort eingesetzt werden, wo kleinste Teile außerhalb einer Führung, z. B. im freien Fall erfaßt werden müssen. Ein typischer Anwendungsfall ist die Auswurfkontrolle an Stanzen und Pressen zur Werkzeugsicherung.

Die Gabel- oder Rahmenlichtschranken weisen in gegenüberliegenden Schenkeln eine Vielzahl von lichtemittierenden Senderelementen und lichtempfindlichen Empfängerelementen auf, die vorzugsweise in Reihe angeordnet sind und zwischen den Schenkeln der Gabel- oder Rahmenlichtschranke eine sensorisch aktive Zone in Form eines Lichtvorhangs oder Lichtteppichs ausbilden.

Je nach Art der verwendeten Empfängerelemente bewirken beliebige Gegenstände, die sich durch die aktive Zone des Lichtvorhangs bzw. Lichtteppichs bewegen und die so beschaffen sind, daß sie dabei das von dem mindestens einen Empfänger empfangene Licht in seiner Stärke vermindern bzw. verändern, eine Erhöhung bzw. anderung des elektrischen Widerstandes oder eine Verminderung bzw. Änderung in der Abgabe elektrischer Energie des bzw. der Empfängerelemente. Diese Änderungen des elektrischen Widerstandes oder der Abgabe elektrischer Energie werden mit Hilfe einer elektronischen Auswertschaltung in geeigneter Weise aufbereitet, um ein definiertes Ausgangssignal zu erhalten. Dabei müssen die Umgebungsverhältnisse der Gabel-oder Rahmenlichtschranke an den jeweiligen Einsatzorten berücksichtigt werden.

Die Auswertschaltung der bekannten Gabel- oder Rahmenlichtschranken weist Summierverstärker auf, deren Eingänge mit den Ausgängen der Empfängerelemente verbunden sind. Dadurch weist die Auswertschaltung eine hohe Fremdlichtempfindlichkeit auf, der bei einer Änderung der Umgebungs-Lichtverhältnisse eine Änderung des elektrischen Widerstandes bzw. der Abgabe elektrischer Energie zur Folge hat. Durch die Verwendung von Filterscheiben können die bekannten Gabel- oder Rahmenlichtschranken bis zu einem gewissen Grad unabhängig von der Fremdlichtempfindlichkeit gemacht werden. Aber selbst extrem teure Filterscheiben mit sehr kleiner Bandbreite erweisen sich als nicht optimal, da sie nicht nur das Fremdlicht sondern auch das Senderlicht dämpfen.

Der Erfindung liegt die Aufgabe zugrunde, eine Vorrichtung der eingangs genannten Art zu schaffen, die bei größtmöglicher Empfindlichkeit für zu erfassende Gegenstände eine minimale Fremdlichtempfindlichkeit aufweist.

Diese Aufgabe wird durch die kennzeichnenden Merkmale des Anspruchs 1 gelöst.

Die erfindungsgemäße Lösung gewährleistet eine maximale Empfindlichkeit bei der Erfassung bewegter Objekte bei gleichzeitig minimaler Fremdlichtempfindlichkeit. Durch die Zusammenfassung von Empfängerelementen zu Gruppen mit einer gleichen Anzahl von mindestens einem Empfängerelement in Verbindung mit einer Auswertung, die nur die Spannungsdifferenzen zwischen einzelnen Empfängerelementgruppen berücksichtigt, wird eine auf alle Elemente einwirkende Fremdlichtbeeinflussung eliminiert, so daß durch die jetzt mögliche Wahl von wesentlich größeren Verstärkungsfaktoren die Objektempfindlichkeit beträchtlich ansteigt.

Die erfindungsgemäße Lösung geht von der Erkenntnis aus, daß sämtliche Empfängerelemente gleichermaßen vom Fremdlichteinfall beeinflußt werden, daß sich dadurch bedingt die Ausgangssignale der Empfängerelemente analog dazu ändern, jedoch jeweils um den gleichen Betrag und in miteinander übereinstimmender Richtung. Dadurch entstehen infolge des Fremdlichtes keine oder nur sehr geringe Differenzsignale. Im Unterschied dazu entstehen erwünschte Differenzsignale durch die Abschattung von mindestens einem und höchstens einem weniger als der Gesamtanzahl der Empfängerelemente.

Durch die rein elektronischen Auswertung in Verbindung mit einer Verknüpfung von Standard-Bauelementen gewinnt man zusätzlich den erheblichen Vorteil, daß an die Senderelemente, die Empfängerelemente und die ggf. verwendeten Filterscheiben nur geringe Ansprüche hinsichtlich der Lichtwellenlängen-Selektivität dieser Elemente gestellt werden müssen.

Bei der erfindungsgemäßen Lösung steigt das Verhältnis von Objektempfindlichkeit zu Fremdlichtempfindlichkeit mit der Anzahl der aus den Empfängerelementen gebildeten Gruppen ausgehend von einer Gesamtanzahl von Empfängerelementen und mit der Annäherung der Gruppenbildung der einzelnen Empfängerelemente zu einer reinen Reihenschaltung sowie durch entsprechende Auswahl der Sender- und Empfängerelemente derart, daß sie in ihren Eigenschaften möglichst vollständig aneinander angeglichen werden.

Eine vorteilhafte Weiterbildung der erfindungsgemäßen Lösung ist dadurch gekennzeichnet, daß die Auswerteinrich tung dynamisch ausgebildet ist und daß eine Impulsunterdrückungsstufe mit den Empfängerelementegruppen verbunden ist, die bei einem Durchtritt von Gegenständen mit geringer Geschwindigkeit Zweitimpulse am Ausgang der Folgestufe unterdrückt.

Diese Weiterbildung der erfindungsgemäßen Lösung verhindert bei einem dynamischen Schaltverhalten der Gabel- oder Rahmenlichtschranke das Auftreten unerwünschter Zweitimpulse, die dann auftreten, wenn sich ein zu erfassender Gegenstand über eine bestimmte Zeitdauer hinaus in der aktiven Zone der Lichtschranke befindet, so daß bei dem Austritt des zu erfassenden Objekts aus der aktiven Zone erneut ein Impuls erzeugt wird.

Eine weitere vorteilhafte Ausgestaltung der erfindungsgemäßen Lösung ist dadurch gekennzeichnet, daß die Empfängerelementegruppen in Reihe zu jeweils einem Widerstand zur Bildung eines Spannungsteilers geschaltet sind und eine der Anzahl Empfängerelementegruppen entsprechende Anzahl Differenzverstärker vorgesehen ist, deren Eingänge mit jeweils unterschiedlichen Spannungsteilern derart verbunden sind, daß sämtliche Spannungsteiler zyklisch an Eingänge der Differenzverstärker angeschlossen sind und daß die Ausgänge der Differenzverstärker mit den Eingängen der Folgestufe verbunden sind.

Diese Ausgestaltung der erfindungsgemäßen Lösung macht von dem Prinzip eines Spannungsteilers Gebrauch, indem in Reihe zu den Ausgängen der Empfängerelementegruppen Widerstände geschaltet sind, an deren Verbindung die invertie renden bzw. nichtinvertierenden Eingänge der nachgeschalteten Differenzverstärker angeschlossen sind. Durch zyklisches Vertauschen der Anschlüsse und Verwendung jedes Eingangs eines Differenzverstärkers nur für einen Anschluß werden die Empfängerelementegruppen gleich gewichtet, so daß die erwünschte Fremdlichtunabhängigkeit und hohe Empfindlichkeit von zu erfassenden Objekten gewährleistet ist.

Vorteilhafte Ausgestaltungen und Weiterbildungen der Erfindung sind in den Unteransprüchen gekennzeichnet.

Die Erfindung wird nachstehend an Hand der in der Zeichnung dargestellten Ausführungsbeispiele näher erläutert. Es zeigen:

Figur 1 ein Blockschaltbild mit vier Empfängerelementegruppen;

Figur 2 ein detailliertes Schaltbild mit drei Empfängerelementegruppen und

Figur 3 eine symbolische Darstellung der Verknüpfung von Differenzverstärkern mit den Spannungsteilern einer Auswerteinrichtung.

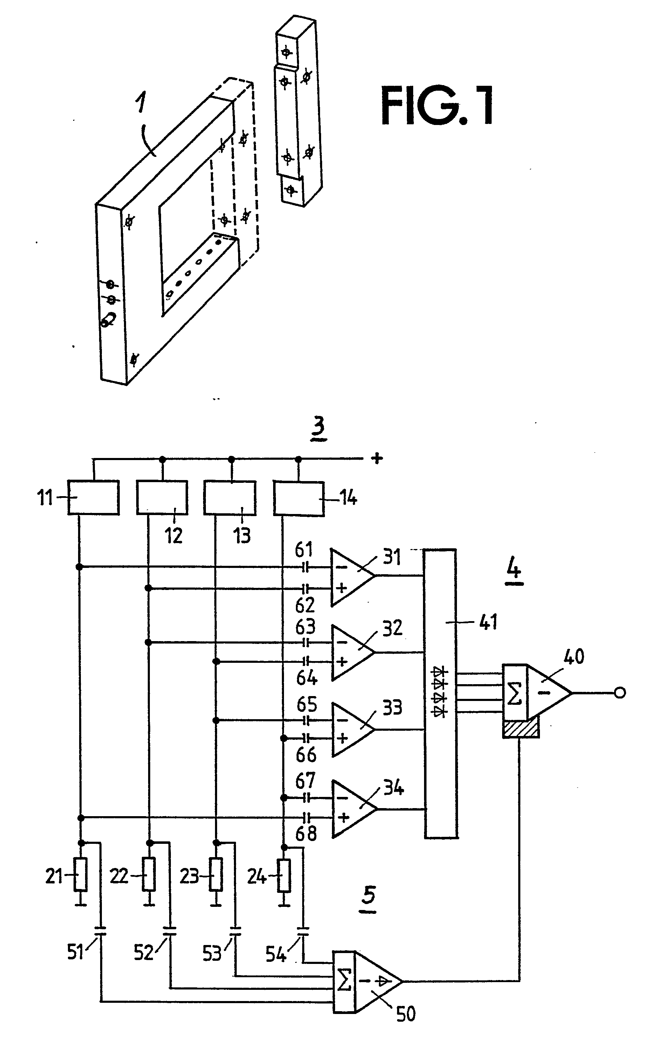

Das in Figur 1 dargestellte Blockschaltbild zeigt vier Empfängerelementegruppen 11, 12, 13, 14, wobei im folgenden von Empfängerelementen ausgegangen wird, deren elektrischer Widerstand abhängig von der Stärke des empfangenen Lichtes ist, beispielsweise Fotodioden oder Fototransistoren.

Die Empfängerelementegruppen 11, 12, 13, 14 enthalten jeweils eine gleiche Anzahl von n Empfängerelementen, wobei n = 1, 2, 3 ... ist. Die Empfängerelemente innerhalb jeder Empfängerelementegruppe sind wahlweise parallel, in Reihe oder in Gruppenschaltung zusammengefaßt geschaltet. Die mechanische Anordnung der Empfängerelemente entspricht deren elektrischer Gruppierung, d. h. die Empfängerelemente ein und derselben Empfängerelementegruppe sind in einem Schenkel der Gabel- oder Rahmenlichtschranke 1 nebeneinander angeordnet.

In Reihe zu jeder Empfängerelementegruppe 11, 12, 13, 14 ist ein Widerstand 21 22, 23, 24 geschaltet, so daß jede Empfängerelementegruppe 11, 12, 13, 14 zusammen mit dem in Reihe geschalteten Widerstand 21, 22, 23, 24 einen Spannungsteiler bildet. Durch die Abschattung mindestens eines Empfängerelementes der Gruppen 11, 12, 13, 14 verändert sich somit die Spannung an dem betreffenden Spannungsteiler.

Die Ausgänge der Spannungsteiler sind über Kondensatoren 61 bis 68 mit den Eingängen einer der Anzahl der Spannungsteiler entsprechenden Anzahl von Differenzverstärkern 31, 32, 33, 34 verbunden. Dabei sind die Ausgänge der Spannungsteiler jeweils mit einem invertierenden und einem nichtinvertierenden Eingang eines Differenzverstärkers 31, 32, 33 ,34 verbunden, wobei die Eingänge eines Differenzverstärkers 31 bzw. 32 bzw. 33 bzw. 34 nur an die Ausgänge unterschiedlicher Spannungsteiler angeschlossen sind. Durch zyklisches Vertauschen der Verbindung der Ausgänge der Spannungsteiler mit den Eingängen der nachgeschalteten Differenzverstärker 31, 32, 33, 34 wird eine gleiche Bewertung sämtlicher Empfängerelementegruppen erzielt.

So ist beispielsweise die Empfängerelementegruppe 11 über einen Kondensator 61 mit dem invertierenden Eingang eines ersten Differenzverstärkers 31 und über einen Kondensator 68 mit dem nichtinvertierenden Eingang eines vierten Differenzverstärkers 34 verbunden.

Die Ausgänge der Differenzverstärker 31, 32, 33, 34 sind mit einer Folgestufe 4 verbunden, die ein Entkopplungsglied 41 und einen Summierverstärker 40 enthält. Das Entkopplungsglied 41 verhindert, daß die stets vorhandenen gegenläufigen Ausgangsspannungen der Differenzverstärker 31, 32, 33, 34 sich gegenseitig aufheben. Dieses Entkopplungsglied 41 kann Bestandteil der Differenzverstärker 31, 32, 33, 34 oder des Summierverstärkers 40 bzw. eine selbstständige Stufe sein.

Im Ausführungsbeispiel gemäß Figur 1 ist die Auswerteinrichtung als dynamische Verstärkerstufe ausgebildet. Dringt ein zu erfassender Gegenstand in den Lichtteppich ein, so sinkt die Spannung am Ausgang der betreffenden Empfängerelementegruppe ab, so daß die betreffenden Kondensatoren 61 bis 68 umgeladen werden bis sie einen stabilen Zustand erreicht haben. Bei langsam bewegten Gegenständen stellt sich somit ein stabiler Zustand ein, der zu einer erneuten Umladung und damit Impulsauslösung führt, wenn der betreffende Gegenstand aus dem Lichtteppich austritt.

Zur Unterdrückung dieses unerwünschten Zweitimpulses (Austrittimpulses) ist eine Impulsunterdrückungsstufe 5 vorgesehen, die aus einem Summierverstärker 50 besteht, dessen Eingänge über Kondensatoren 51, 52, 53, 54 mit den Ausgängen der Spannungsteiler verbunden sind und dessen Ausgang einen Sperr- oder Blockiereingang des Summierverstärkers 40 der Folgestufe 4 mit einer gegenläufigen Spannung ansteuert, so daß der Summierverstärker 40 der Folgestufe 4 bei Auftreten eines Zweitimpulses (Austrittimpulses) blockiert wird.

Am Ausgang des Summierverstärkers 40 der Folgestufe 4 steht somit mit der Erfassung eines Gegenstandes durch mindestens ein Empfängerelement ein Signal an, das daran anschließend digitalisiert, zeitlich definiert und evtl. erneut verstärkt werden kann.

Die in Figur 1 dargestellte Vorrichtung weist somit ein dynamisches Schaltverhalten auf, so daß nur eine schnelle Unterbrechung einer oder mehrerer Lichtstrahlen in einen Ausgangsimpuls umgewandelt wird. Gegenstände, die in der Gabel- oder Rahmenlichtschranke liegen oder sich nur langsam hindurchbewegen, werden nicht erkannt.

Durch ein eingebautes Potentiometer kann die Ansprechempfindlichkeit der Vorrichtung eingestellt werden. Ein weiteres Potentiometer ermöglicht eine Ausgangsimpulsverlängerung, wobei die Impulsverlängerung unabhängig von der Geschwindigkeit der zu erfassenden Gegenstände arbeitet.

Durch den speziellen Schaltungsaufbau eignet sich die Vorrichtung bei dynamischem Schaltverhalten für den Einsatz unter unterschiedlichen Einsatzbedingungen, so daß z. B. ein Staub- oder Ölfilm keinen Einfluß auf die Funktion der Vorrichtung hat. Durch dieses Verhalten der Vorrichtung ist es auch möglich, Gegenstände durch transparente Materialien hindurch zu erfassen. In die Gabel oder den Rahmen der Gabel- oder Rahmenlichtschranke ständig hineinragende Maschinenteile haben auf die Funktion der restlichen nicht unterbrochenen Sender- und Empfangselemente keinen Einfluß.

In dem Blockschaltbild gemäß Figur 1 kann anstelle eines Summierverstärkers 40 mit vorgeschaltetem Entkopplungsglied 41 ein ODER-Glied verwendet werden, dessen Ausgang beispielsweise mit einem nichtinvertierenden Eingang eines UND- Gliedes verbunden ist, dessen invertierender Eingang an den Ausgang des Summierverstärkers 50 der Impulsunterdrückungsstufe 5 angeschlossen ist, so daß ein Ausgangimpuls des ODER-Gliedes nur dann zu einem Zählimpuls führt, wenn kein Zweitimpuls vorliegt.

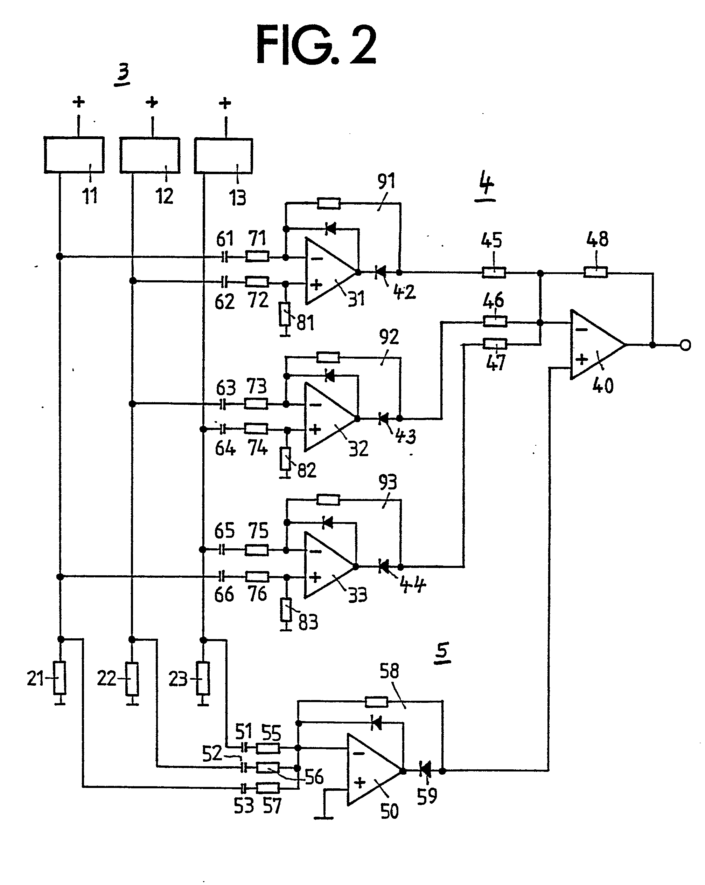

Figur 2 zeigt ein detailliertes Schaltbild einer Vorrichtung gemäß Figur 1 mit drei Empfängerelementegruppen 11, 12, 13.

Die Empfängerelementegruppen 11, 12, 13 sind analog zur Darstellung gemäß Figur 1 in Reihe zu Widerständen 21, 22, 23 zur Bildung entspre- chender Spannungsteiler geschaltet. Die Span- nungsteiler sind mit dem invertierenden sowie nichtinvertierenden Eingang zweier unterschiedlicher Differenzverstärker 31, 32, 33 über die Reihenschaltung eines Kondensators 61 bis 66 und eines Widerstandes 71 bis 76 verbunden.

Der nichtinvertierende Eingang der Differenzverstärker 31, 32, 33 ist über einen Widerstand 81, 82, 83 mit Masse-oder Bezugspotential verbunden, während der Ausgang der Differenzverstärker 31, 32, 33 über ein Rückkopplungsglied 91, 92, 93 auf den invertierenden Eingang zurückgekoppelt ist. Im dargestellten Ausführungsbeispiel besteht das Rückkopplungsglied 91, 92, 93 aus der Parallelschaltung einer kathodenseitig mit dem invertierenden Eingang der Differenzverstärker 31, 32, 33 verbundenen Diode mit einer Reihenschaltung aus einem Widerstand und einer weiteren Diode 42, 43, 44. Der Ausgang der Differenzverstärker 31, 32, 33 ist mit der Kathode dieser Diode 42, 43, 44 verbun- den.

Die solchermaßen beschalteten Differenzver- stärker 31, 32, 33 bilden jeweils einen einweggleichrichtenden Differenzverstärker bei denen die Schwellspannungen der Dioden 42, 43, 44 durch die große Verstärkungsreserve quasi eliminiert werden.

Die Anoden der Dioden 42, 43, 44 sind über Widerstände 45, 46, 47 mit dem invertierenden Eingang eines weiteren Differenzverstärkers 40 verbunden, wobei an diesen nur negative Spannungen weitergegeben werden. Der Ausgang des weiteren Differenzverstärkers 40 ist über einen Widerstand 48 auf den invertierenden Eingang zurückgekoppelt.

Der nichtinvertierende Eingang des weiteren Differenzverstärkers 40 ist mit dem Ausgang einer Impulsunterdrückungsstufe 5 verbunden, die aus ebenfalls einem Differenz verstärker 50 besteht, dessen invertierender Eingang über die Reihenschaltung jeweils eines Kondensators 51 bis 53 und eines Widerstandes 55 bis 57 mit dem Ausgang der Spannungsteiler verbunden ist. Der Ausgang des Differenzverstärkers 50 ist über ein Rückkopplungsglied 58 auf den invertierenden Eingang zurückgekoppelt und mit der Kathode einer Diode 59 verbunden, deren Anode an den nichtinvertierenden Eingang des weiteren Differenzverstärkers 40 angeschlossen ist. Die Impulsunterdrückungsstufe 5 ist durch ihre Beschaltung ein einweggleichrichtender Summierverstärker für negative Ausgangsspannungen.

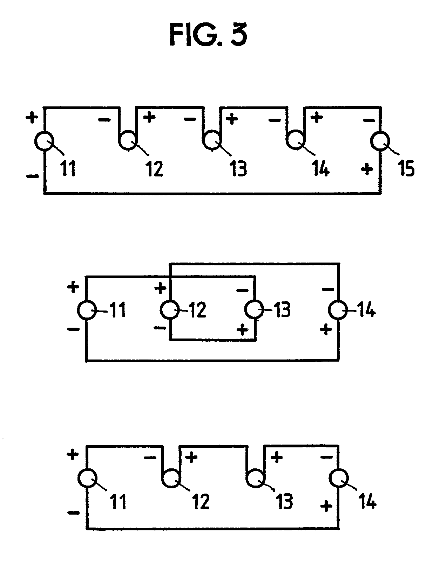

In Figur 3 sind verschiedene Möglichkeiten des Anschlusses der invertierenden und nichtinvertierenden Eingänge der Differenzverstärker an die Ausgänge der Spannungsteiler dargestellt. In dieser symbolischen Darstellung entsprechen die Kreise den einzelnen Spannungsteilerausgängen, während die Differenzverstärker durch Klammern symbolisiert sind. Analog zur Darstellung gemäß Figur 3 kann eine beliebige Verknüpfung auch einer größeren Anzahl von Spannungsteilern bzw. Differenzverstärkern vorgenommen werden.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch machen. Insbesondere beschränkt sich die Ausführung nicht auf die Realisierung nur mit sogenannten Operationsverstärkern, sondern läßt sich vorteilhaft auch mit zusätzlicher programmierter Logik - vorzugsweise unter Verwendung eines Mikroprozessors - realisieren.

## Ansprüche

1. Vorrichtung zur Erfassung einzelner Gegenstände mit einer Sensoreinrichtung, die mehrere beabstandet zueinander angeordnete Sender- und Empfängerelemente aufweist, zwischen denen die einzelnen Gegenstände hindurchtreten und einer Auswerteinrichtung,
**dadurch gekennzeichnet, daß**
die Empfängerelemente (3) in mindestens drei gleichgroße Gruppen (11, 12, 13, 14) mit benachbart zueinander angeordneten Empfängerelementen (3) aufgeteilt sind, daß die Auswerteinrichtung mindestens zwei Differenzbildner (31, 32, 33, 34) enthält und daß die Ausgänge von jeweils zwei Empfängerelementegruppen (11, 12, 13, 14) mit den Eingängen jeweils eines Differenzbildners (31, 32, 33, 34) verbunden sind, deren Ausgänge ein die Erfassung eines Gegenstandes anzeigendes Signal abgeben.

2. Vorrichtung nach Anspruch 1, **dadurch gekennzeichnet**, daß die Ausgänge der Differenzbildner (31, 32, 33, 34) mit den Eingängen einer Folgestufe (4) verbunden sind, deren Ausgang ein die Erfassung eines Gegenstandes anzeigendes Signal abgibt.

3. Vorrichtung nach Anspruch 2, **dadurch gekennzeichnet**, daß die Folgestufe (4) aus einem ODER-Glied besteht.

4. Vorrichtung nach Anspruch 2, **dadurch gekennzeichnet**, daß die Folgestufe (4) aus einem Summierverstärker (40) mit vorgeschaltetem Entkopplungsglied (41) besteht.

5. Vorrichtung nach einem der vorangehenden Ansprüche, **dadurch gekennzeichnet**, daß die Auswerteinrichtung dynamisch ausgebildet ist und daß eine Impulsunterdrückungsstufe (5) mit den Empfängerelementegruppen (11, 12, 13, 14) verbunden ist, die bei einem Durchtritt von Gegenständen mit geringer Geschwindigkeit Zweitimpulse am Ausgang der Folgestufe (4) unterdrückt.

6. Vorrichtung nach einem der vorangehenden Ansprüche, **dadurch gekennzeichnet**, daß die Empfängerelementegruppen (11, 12, 13, 14) in Reihe zu jeweils einem Widerstand (21, 22, 23, 24) zur Bildung eines Spannungsteilers geschaltet sind und daß eine der Anzahl Empfängerelementegruppen (11, 12, 13, 14) entsprechende Anzahl Differenzverstärker (31, 32, 33, 34) vorgesehen ist, deren Eingänge mit jeweils unterschiedlichen Spannungsteilern (11, 21; 12, 22; 13, 23; 14, 24) derart verbunden sind, daß sämtliche Spannungsteiler (11, 21; 12, 22; 13, 23; 14, 24) zyklisch an Eingänge der Differenzverstärker (31, 32, 33, 34) angeschlossen sind und daß die Ausgänge der Differenzverstärker (31, 32, 33, 34) mit den Eingängen der Folgestufe (4) verbunden sind.

7. Vorrichtung nach Anspruch 6, **dadurch gekennzeichnet**, daß den Eingängen der Differenzverstärker (31, 32, 33, 34) jeweils ein Kondensator (61, 62; 63, 64; 65, 66; 67,68) vorgeschaltet ist.

8. Vorrichtung nach einem der vorangehenden Ansprüche, **dadurch gekennzeichnet**, daß die Impuls-Unterdrückungsstufe (5) eingangsseitig an die Spannungsteiler (11, 21; 12, 22; 13, 23; 14, 24) und ausgangsseitig an einen Sperreingang der Folgestufe (4) angeschlossen ist.

9. Vorrichtung nach einem der vorangehenden Ansprüche, **dadurch gekennzeichnet**, daß die Senderelemente aus lichtemittierenden Bauelementen und die Empfängerelemente aus lichtempfindlichen Bauelementen bestehen, die in gegenüberliegenden Schenkeln einer Gabel- oder Rahmenlichtschranke (1) angeordnet sind, daß die Impulsunterdrückungsstufe (5) aus einem Differenzverstärker (50) besteht, an dessen einem Eingang über die Reihenschaltung eines Kondensators (51, 52, 53, 54) mit einem Widerstand (55, 56, 57, 58) die Spannungsteiler (11, 21; 12, 22; 13, 23; 14, 24) angeschlossen sind, dessen anderer Eingang mit Bezugspotential beaufschlagt ist und dessen Ausgang mit einem Eingang der als Differenzverstärker (40) ausgebildeten Folgestufe verbunden ist, an deren anderem Eingang die Ausgänge der Differenzverstärker (31, 32, 33, 34) über Entkopplungsdioden (41, 42, 43, 44) angeschlossen sind.

FIG.1

# FIG. 2

# FIG. 3